# FASCICULE DE BREVET EUROPEEN

(11) **EP 1 841 066 B1**
(45) Date de publication et mention de la délivrance du brevet: **09.06.2010**
(21) Numéro de dépôt: 07105026.4
(22) Date de dépôt: 27.03.2007
(51) Int. Cl.: H03K 5/19, G06F 11/00

(54) **Estimation de gigue d'un signal d'horloge**
Einschätzung des Jitters eines Taktsignals
Estimating the jitter of a clock signal

(30) Priorité: 28.03.2006 FR 0651065
(43) Date de publication de la demande: 03.10.2007
(73) Titulaire: ST MICROELECTRONICS S.A., 92120 Montrouge (FR)
(72) Inventeur: Le-Gall, Hervé, 38410 Saint Martin d'Uriage (FR)
(74) Mandataire: de Beaumont, Michel

(56) Documents cités:
- US-A- 5 663 970
- US-A- 5 670 901
- US-A- 5 930 275

## Description

### Domaine de l'invention

La présente invention concerne de façon générale les circuits électroniques et, plus particulièrement, les circuits comportant des éléments de génération d'un ou plusieurs signaux périodiques.

Un exemple d'application de la présente invention concerne les processeurs intégrés comportant un circuit de génération de signaux d'horloge à partir d'une horloge de référence.

L'invention concerne plus particulièrement le test de synchronisation d'un signal d'horloge généré en interne par un circuit électronique par rapport à une horloge de référence interne ou externe.

### Exposé de l'art antérieur

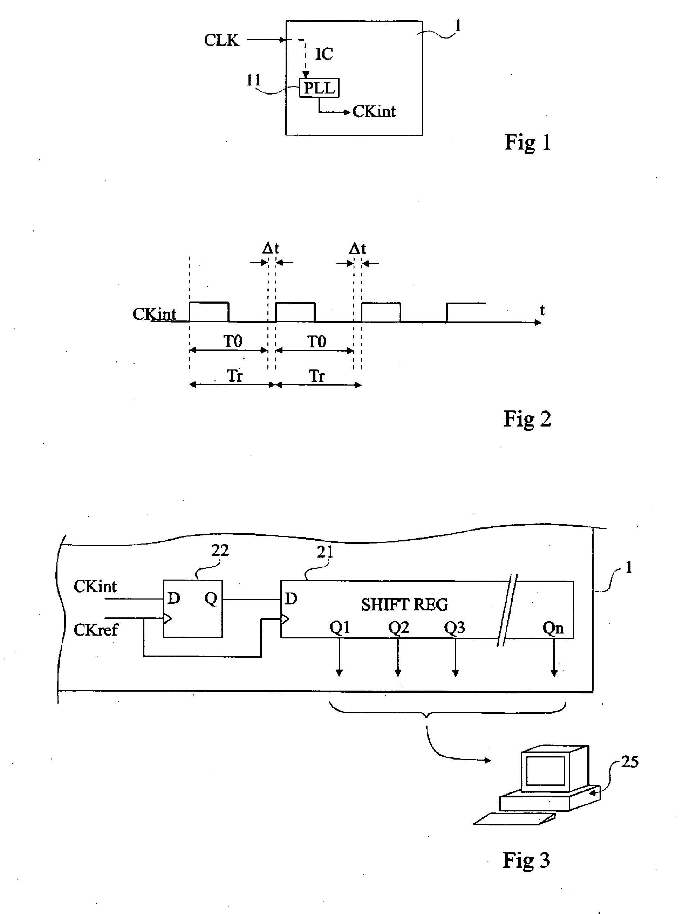

La figure 1 représente, de façon très schématique et partielle, un exemple de circuit électronique 1 du type auquel s'applique la présente invention. Un tel circuit comporte de multiples fonctions non représentées (notamment s'il s'agit d'un processeur) et au moins un circuit 11 (PLL), par exemple de type boucle à verrouillage de phase, de génération d'au moins un signal d'horloge interne CKint à partir d'un signal d'horloge CLK par exemple externe.

Un problème présent dans les circuits électroniques pilotés à partir de signaux d'horloge ou de comptage est de s'assurer que ces signaux suivent bien une valeur attendue, c'est-à-dire ne subissent pas de gigue par rapport au signal à partir duquel ils sont générés et plus généralement par rapport à un signal de référence.

La figure 2 illustre, par un chronogramme, un exemple de phénomène de gigue d'un signal CKint dont la période réelle Tr est légèrement supérieure à une période attendue T0. Le décalage Δt entre les deux périodes engendre une désynchronisation de l'horloge CKint qui risque d'entraîner des problèmes fonctionnels du circuit.

Un tel bruit ou gigue de phase est de plus en plus critique avec l'augmentation de la fréquence du signal, car les résultats de calculs (par exemple, d'un compteur) dérivent rapidement par rapport à une valeur attendue.

Une première méthode pour tester la dérive d'un signal d'horloge consiste à prélever le signal généré par le circuit et à mesurer, avec un équipement externe, un éventuel écart par rapport à un signal de référence. Une telle méthode reste accessible pour des fréquences relativement basses (quelques centaines de kilohertz) mais ne peut plus être utilisée pour des fréquences élevées (plusieurs mégahertz, voire centaines ou milliers de mégahertz) car le bruit rajouté par les éléments de mesure externes et la connectique jusqu'au point de mesure ne peut plus être négligé.

Une deuxième méthode consiste à intégrer, dans le circuit à tester, un dispositif fournissant une information relative au déphasage du signal d'horloge interne par rapport à une horloge de référence afin de permettre une exploitation externe des résultats.

La figure 3 représente, de façon très schématique et sous forme de blocs, un exemple classique d'un tel dispositif. En figure 3, seul le dispositif de mesure intégré dans le circuit 1 a été représenté. Ce dispositif est constitué d'un registre à décalage 21 à base de bascules D dont une entrée de données reçoit la sortie (par exemple, non inversée Q) d'une bascule d'échantillonnage 22. L'entrée de données D de la bascule 22 reçoit le signal d'horloge interne CKint à tester. La bascule 22 et le registre à décalage 21 reçoivent, sur leurs entrées d'horloge respectives, un signal CKref constituant une horloge de référence d'une fréquence du même ordre de grandeur que le signal à mesurer. Les n sorties Q1 à Qn du registre à décalage 21 sont fournies à l'extérieur du circuit 1 à un système 25 d'exploitation des mesures (par exemple, un microordinateur). Le rôle du registre à décalage 21 est de paralléliser les informations successives sur les fronts d'horloge et leur décalage éventuel, de façon à fournir une information exploitable malgré la fréquence élevée.

Un inconvénient de cette deuxième méthode est qu'il est nécessaire de charger les données fournies par le registre à décalage 21 dans un système externe afin de pouvoir exploiter ces données et déterminer une éventuelle gigue entre les deux signaux d'horloge. En pratique, un tel dispositif est limité à la caractérisation du produit et ne permet pas un test d'une éventuelle gigue d'horloge d'un produit fabriqué, par exemple, dans un test final avant décision éventuelle de mise au rebut d'un produit, ou dans la vie du produit.

### Résumé de l'invention

La présente invention vise à pallier tout ou partie des inconvénients des systèmes connus de test de gigue d'horloge.

L'invention vise plus particulièrement à proposer un circuit d'estimation de la gigue éventuelle d'un signal d'horloge généré par un circuit électronique par rapport à un signal de référence.

L'invention vise également à proposer une solution compatible avec une intégration du circuit de test dans le circuit électronique lui-même.

L'invention vise également à proposer une solution compatible avec la mise en oeuvre d'un test des produits individuellement après fabrication.

Pour atteindre tout ou partie des ces objets ainsi que d'autres, la présente invention prévoit un procédé d'estimation de gigue d'un premier signal périodique par rapport à un deuxième signal périodique comportant des étapes de :
échantillonner le premier signal au moyen du deuxième ;
fournir le résultat de l'échantillonnage en entrée d'un registre à décalage déclenché par le deuxième signal ;
comparer au moins les deux premiers états et le dernier état d'un mot courant formé à partir de sorties parallèles du registre à décalage par rapport à un mot de référence; et
compter le nombre d'occurrences du mot de référence dans une période de mesure donnée.

Selon un mode de mise en oeuvre de la présente invention, le nombre d'occurrences est comparé à un seuil et est périodiquement réinitialisé, la gigue étant considérée comme acceptable tant que ce seuil n'est pas atteint.

Selon un mode de mise en oeuvre de la présente invention, les premiers et derniers bits du mot de référence sont identiques, le deuxième bit de ce mot étant dans un état inverse.

Selon un mode de mise en oeuvre de la présente invention, le mot de référence comporte entre un et trois premiers bits dans un premier état, entre un et trois bits suivants dans un deuxième état inverse au premier état et entre un et trois derniers bits dans le premier état.

Selon un mode de mise en oeuvre de la présente invention, le mot courant fourni par le registre à décalage est comparé à un deuxième mot de référence inverse par rapport au premier.

Selon un mode de mise en oeuvre de la présente invention, la période de mesure est choisie en fonction de la période de l'horloge de référence.

Selon un mode de mise en oeuvre de la présente invention, le nombre de bits du mot de référence est compris entre quatre et douze, de préférence entre cinq et sept.

Selon un mode de mise en oeuvre de la présente invention, le mot courant est formé de toutes les sorties du registre à décalage.

Selon un mode de mise en oeuvre de la présente invention, le mot courant est formé d'une partie seulement des sorties du registre à décalage.

L'invention prévoit également un dispositif d'estimation de gigue d'un signal périodique par rapport à un signal de référence, comportant un registre à décalage dont une entrée reçoit le signal périodique, échantillonné par le signal de référence, caractérisé en ce qu'il comporte :
un comparateur d'un mot constitué des sorties parallèles du registre à décalage par rapport à un motif de référence ;
au moins un compteur d'occurrences d'une comparaison positive fournie par le premier comparateur ; et
un deuxième comparateur du résultat du compteur d'occurrences par rapport à un seuil.

### Brève description des dessins

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles:
la figure 1 décrite précédemment représente de façon très schématique et partielle un circuit électronique du type auquel s'applique la présente invention ;
la figure 2 décrite précédemment est un chronogramme illustrant une gigue d'horloge ;
la figure 3 décrite précédemment est destinée à exposer l'état de la technique et le problème posé ;
la figure 4 illustre, par des chronogrammes, un exemple de gigue d'un signal périodique généré par un circuit électronique par rapport à un signal de référence ;
la figure 5 est un agrandissement des chronogrammes de la figure 4 autour d'un instant où les deux signaux sont en phase ;
la figure 6 représente la caractéristique de probabilité cumulative d'apparition d'un état donné en fonction du temps, pour un signal d'horloge généré par un circuit électronique ;
la figure 7 représente, de façon très schématique et sous forme de blocs, un mode de réalisation d'un circuit d'estimation de la gigue d'un signal périodique selon la présente invention ;
la figure 8 représente, de façon très schématique, un détail du circuit de la figure 7 ;
la figure 9 représente des chronogrammes illustrant le fonctionnement du circuit de détection de l'invention ; et
les figures 10A et 10B illustrent des variantes d'un motif de détection d'un dispositif de l'invention.

### Description détaillée

Par souci de clarté, de mêmes éléments ont été désignés par de mêmes références aux différentes figures. De plus, seuls les étapes et éléments utiles à la compréhension de l'invention ont été représentés et seront décrits. En particulier, les circuits de génération des signaux périodiques n'ont pas été illustrés, l'invention étant compatible avec tout circuit classique de génération d'un signal périodique. De même, les parties du circuit électronique concerné, autres que les dispositifs de détection proprement dits n'ont pas été illustrés, l'invention étant là encore compatible avec tout circuit électronique classique exploitant un signal d'horloge.

La présente invention tire son origine d'une nouvelle analyse du phénomène de gigue d'une horloge par rapport à une horloge de référence et, plus particulièrement, d'une exploitation statistique des états du signal d'horloge mesuré par rapport à l'horloge de référence.

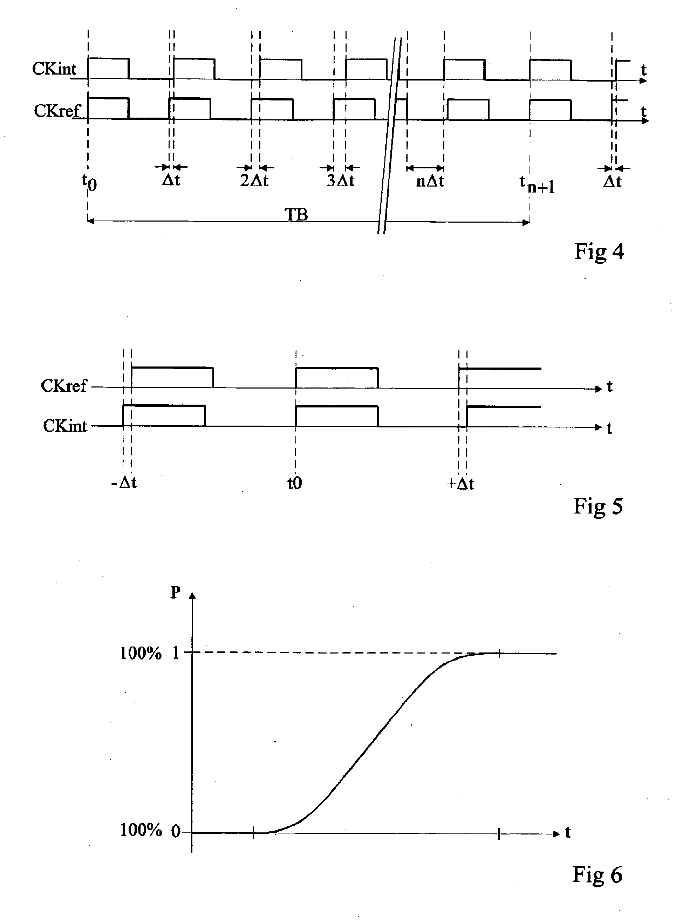

La figure 4 illustre, par des chronogrammes représentant un exemple d'allure temporelle d'un signal CKint à mesurer par rapport à un signal de référence CKref, un exemple de gigue de phase entre deux signaux périodiques. En supposant que les signaux synchrones à un instant t₀, le déphasage du signal CKint par rapport au signal CKref augmente successivement d'une même valeur Δt à chaque période d'horloge jusqu'à ce que les deux signaux redeviennent synchrones à un instant tₙ₊₁, après n+1 périodes du signal d'horloge de référence, le signal à mesurer n'ayant, pendant ce temps de battement TB écoulé, que n périodes. La figure 4 illustre la possibilité d'estimer le défaut de synchronisme d'un signal d'horloge de fréquence élevée à partir d'une mesure à une fréquence plus faible (période TB) en exploitant le fait que, même avec gigue, les signaux ont périodiquement des fronts communs.

Pour simplifier, les fronts de signaux sont supposés instantanés. En pratique, ils suivent une pente entre les deux états haut et bas et inversement. Cela ne change toutefois pas les principes de l'invention.

La figure 5 représente un agrandissement des chronogrammes de la figure 4 autour de l'instant t₀. Cette figure illustre que, si le déphasage est de +Δt dans la période qui suit l'instant t₀ synchrone des deux signaux, ce déphasage est de -Δt à la période qui précède. Par conséquent, on peut considérer qu'en comparant les états respectifs des deux signaux (ou en les combinant par un ET), les fronts synchronisés des deux signaux sont, quel que soit l'importance de la gigue, encadrés par des états déterminés et inverses l'un de l'autre.

La figure 6 représente, en fonction du temps t, la densité de probabilité cumulative P d'une comparaison des états des signaux d'horloge en fonction du temps. Comme la probabilité d'obtenir un état 0 ou un état 1 en comparant deux signaux non synchrones suit une gaussienne, cela se traduit par une distribution cumulative en forme de S entre des instants où on est sûr d'obtenir un état 0 (déphasage dans un sens) ou un état 1 (déphasage dans l'autre sens). La notion d'état 0 ou 1 s'entend en comparant les deux signaux à des instants d'échantillonnage.

L'invention tire profit de cette distribution pour considérer que les états qui entourent des fronts alignés des signaux à comparer sont hors de cette distribution et ont donc des états déterminés (respectivement, 0 et 1).

L'invention prévoit alors de comparer un mot contenu dans un registre à décalage (sorties parallèles d'une série de bascules), piloté par un signal de référence et dont l'entrée de données reçoit le signal à mesurer échantillonné, à un mot dont les deux premiers bits ou deux premiers groupes de bits ont des états inversés l'un par rapport à l'autre et dont le dernier bit ou le dernier groupe de bits a un état identique à celui du premier bit. Ainsi, l'invention prévoit un motif de référence pour estimer la gigue du signal généré par rapport à un signal de référence. Ce motif est comparé aux mots successivement présents sur les sorties du registre à décalage et la fréquence de son apparition fournit une estimation de la gigue du signal d'horloge à mesurer par rapport au signal de référence.

L'invention tire également profit du fait que pour qualifier un produit en terme de gigue d'horloge, il suffit le plus souvent que sa gigue soit inférieure à un seuil. Il n'est donc pas nécessaire de la calculer précisément et son estimation par rapport à un seuil suffit.

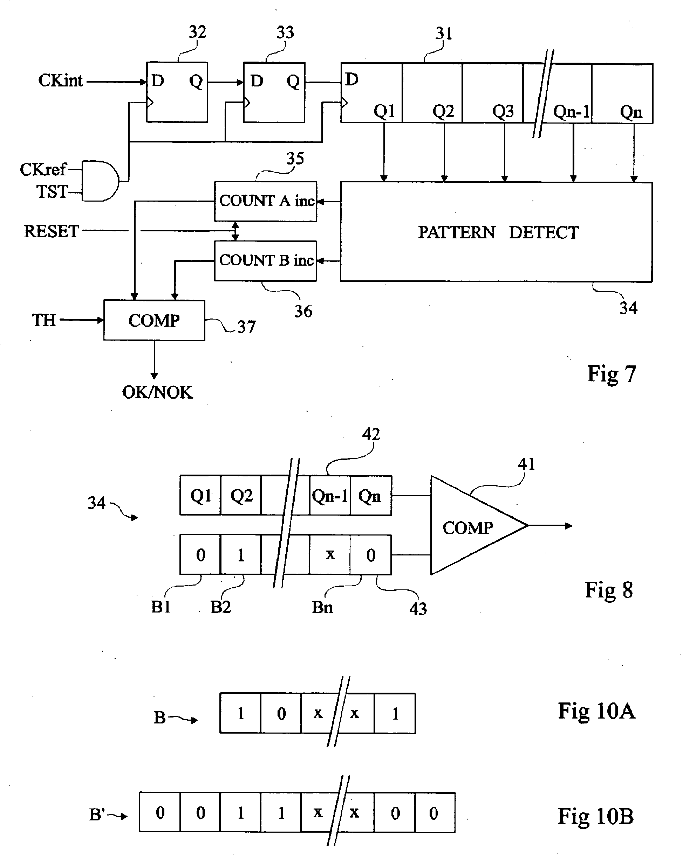

La figure 7 représente, de façon très schématique et sous forme de blocs, un mode de réalisation d'un circuit d'estimation de la gigue d'un signal CKint généré par un circuit électronique par rapport à un signal de référence CKref, les signaux à mesurer et de référence étant de préférence de même ordre de grandeur fréquentiel. Le signal CKint est échantillonné par au moins une première bascule 32 et de préférence par deux bascules 32 et 33 en série, l'entrée de données D de la bascule 33 étant reliée à la sortie Q de la bascule 32. Le signal CKref est appliqué sur les entrées d'horloge des bascules 32 et 33. Un double échantillonnage réduit les incertitudes liées aux temps d'établissement (set up time) et de maintien (hold time) des bascules et aux pentes des fronts des signaux CKint et CKref.

Le résultat de cet échantillonnage est appliqué en entrée d'un registre à décalage 31 constitué préférentiellement de bascules D en série dont les sorties respectives Q1 à Qn sont fournies en parallèle à un détecteur 34 de motifs (PATTERN DETECT). Le rôle du détecteur est de comparer les mots successifs de bits Q1 à Qn par rapport à au moins un motif de référence. Le résultat de la comparaison opérée par le circuit 34 incrémente, en cas d'identité de motif, au moins un premier compteur 35 (COUNT A). De préférence, le résultat de ce compteur est comparé (bloc 37, COMP) par rapport à un seuil TH pour déterminer si la gigue est acceptable (OK) ou non (NOK). De préférence, un deuxième compteur 36 (COUNT B) est incrémenté par le circuit 34 sur la base d'une comparaison du motif fourni par le registre à décalage 31 par rapport à un motif de référence inverse, de façon à mesurer à la fois les fronts montants et les fronts descendants. Les compteurs 35 et 36 sont réinitialisés périodiquement (signal RESET) de sorte que le seuil TH est un seuil d'occurrences dans une période temporelle.

La figure 8 représente, de façon très schématique, un exemple de circuit de détection 34. Fonctionnellement, ce circuit comporte un comparateur 41 (COMP) du mot Q1 à Qn fourni par le registre 31 (transitant le cas échéant par un élément de mémorisation temporaire 42) par rapport à un mot de référence stocké par exemple dans un élément de mémorisation 43 ou câblé dans le circuit. Comme indiqué précédemment, les deux premiers bits B1 et B2 du mot de référence ont des états inverses (par exemple, 0 et 1) et le dernier bit (Bn) a le même état que le premier bit. Les états respectifs des bits intermédiaires sont indifférents, c'est-à-dire que le comparateur 41 ne prend en compte que les deux premiers bits Q1, Q2 et B1, B2 respectivement, et le dernier Qn, respectivement. Ainsi, dans un mode de réalisation simplifié, toutes les sorties parallèles du registre à décalage 31 ne sont pas exploitées.

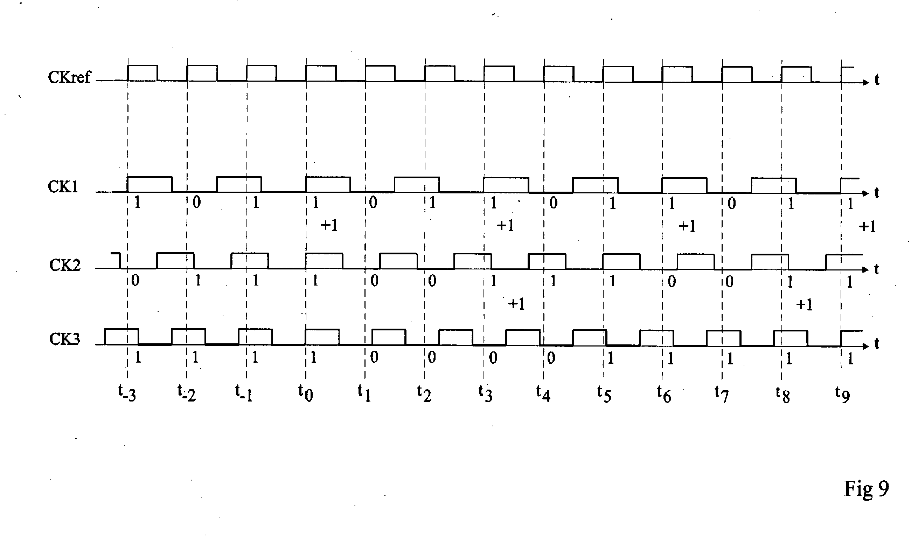

La figure 9 illustre, sous forme de chronogrammes, le fonctionnement d'un circuit de détection selon la présente invention. Un premier chronogramme représente un exemple d'allure du signal de référence CKref. Un deuxième chronogramme CK1 représente un exemple de signal à forte gigue. Un troisième chronogramme CK2 représente un exemple de signal à gigue moyenne constituant, dans cet exemple, le seuil de détection au sens de l'invention. Un quatrième chronogramme CK3 représente un exemple d'allure d'un signal de faible gigue par rapport aux précédents, considéré dans cet exemple comme acceptable par l'estimateur de l'invention. On suppose une comparaison par rapport à des mots de 4 bits, le motif binaire de référence (10X1) ayant un état (X) indifférent.

On suppose qu'à un instant t₀ les signaux sont tous synchrones afin d'illustrer le comptage opéré par l'invention d'après les occurrences du motif de référence dans les mots successifs fournis par le registre à décalage (31, figure 7). Dans l'exemple du signal CK1, l'instant t₀ est un instant où le registre 31 fournit les quatre états des instants t₋₃ à t₀ qui représentent le mot 1011. Par conséquent, le compteur est incrémenté d'un (+1) à partir de l'instant t₀. L'occurrence suivante du motif 1011 intervient à l'instant t₃, puis à l'instant t₆ et à l'instant t₉. L'incrémentation d'un compteur d'occurrences du motif de référence se produit toutes les quatre périodes d'horloge pour le signal CK1.

En prenant l'exemple du signal CK2 dont la gigue est inférieure, la première occurrence d'un motif (ici 1001) conforme au motif de référence intervient à l'instant t₃. L'occurrence suivante apparaît à l'instant t₈. L'apparition du motif est donc moins fréquente que pour le signal CK1.

Quant au troisième signal CK3, le motif 10X1 n'apparaît pas entre les instants t₋₃ et t₉. En supposant que le signal limite correspond au signal CK2 et en ayant fixé de façon adaptée le seuil TH et la fréquence du signal de réinitialisation RESET des deux compteurs, l'estimateur de l'invention considèrera que le signal CK3 est acceptable du point de vue de sa gigue.

Bien entendu, l'exemple de la figure 9 a été exagéré de façon arbitraire pour illustrer l'invention. En pratique, la gigue du signal à mesurer peut ne pas être constante. Toutefois, cela ne change pas le principe exposé ci-dessus.

La figure 10A illustre un exemple de motif de référence D inverse par rapport au motif illustré en figure 8 et servant à détecter les fronts montants au lieu des fronts descendants dans l'exemple de comparaison pris en figure 9. On notera toutefois que, selon le sens de la comparaison entre le signal de référence et le signal à mesurer, les états respectifs sont inversés.

La figure 10B illustre une variante B' du mot de référence dans lequel les deux premiers bits sont dans un premier état (par exemple, 0) et les deux seconds dans l'état inverse (par exemple, 1), les deux derniers bits reproduisant les états des deux premiers. Une telle variante permet de réduire l'incertitude éventuelle sur le front de mesure si celui-ci arrive pendant le changement d'état de l'horloge. Selon une autre variante, les états de départ et de fin sont triplés.

Le choix du nombre de bits du motif de référence, du temps de mesure par rapport à la fréquence (période du signal RESET par rapport à la fréquence du signal CKref) et le seuil TH du comparateur 37 dépendent des caractéristiques souhaitées pour le signal à mesurer. Plus la taille du mot de référence augmente, plus l'estimation est précise mais plus elle est longue à fournir un résultat fiable, c'est-à-dire plus deux réinitialisations des compteurs (signal RESET) doivent être espacées pour s'assurer de disposer d'un signal considéré comme synchronisé. Par exemple, la taille d'un mot de référence est comprise entre 4 et 12 bits, de préférence entre 5 et 7.

En fonction de la gigue que l'on est prêt à accepter pour le circuit électronique, on fixe le nombre maximal d'occurrences acceptables dans la période de mesure au moyen du seuil TH du comparateur 37. La période de mesure est préférentiellement choisie en fonction de la fréquence du signal d'horloge. Pour deux signaux parfaitement en phase, le comptage restera à zéro théoriquement de façon infinie. En pratique, il existe toujours un décalage au bout d'un certain temps mais on considère ce décalage acceptable s'il est suffisamment faible.

De préférence, l'horloge de référence est choisie approximativement d'une fréquence du même ordre de grandeur que l'horloge du signal à mesurer. Plus la fréquence de l'horloge de référence est faible par rapport à la fréquence du signal à mesurer dont elle conditionne l'échantillonnage, plus le temps de mesure est long.

L'horloge de référence est soit fournie depuis l'extérieur du circuit, soit elle provient d'une source différente à l'intérieur de ce circuit. Par source différente, on entend, dans l'exemple d'une boucle à verrouillage de phase, un signal fourni par un oscillateur commandé en tension différent de celui fournissant l'horloge à mesurer.

Un avantage de la présente invention est qu'elle permet une estimation de la gigue d'un signal d'horloge par rapport à un signal de référence à l'intérieur même d'un circuit électronique sans nécessiter de surface d'intégration importante par rapport aux dispositifs classiques se contentant de fournir des données à exploiter de l'extérieur.

Un autre avantage de l'invention est qu'elle rend donc l'estimateur compatible avec une estimation de la gigue du produit fabriqué et ne se limite pas à des tests de caractérisation.

Un autre avantage de la présente invention est qu'elle est compatible avec une interprétation numérique simple (état binaire d'un drapeau) du résultat de l'estimation.

Un autre avantage de la présente invention est que la comparaison des mots courants et de référence peut s'effectuer à chaque période de l'horloge de référence. Le fait que tout soit interne et la simplicité des circuits requis (notamment, l'absence d'accumulation autrement que celle des n premiers cycles d'horloge par le registre à décalage) rend possible une telle détection.

Bien entendu, la présente invention est susceptible de diverses variantes et modifications qui apparaîtront à l'homme de l'art. En particulier, bien que l'invention ait été décrite en relation avec un signal d'horloge fourni par une boucle à verrouillage de phase, elle s'applique plus généralement quelle que soit la source du signal d'horloge. Par exemple, l'invention s'applique si ce signal est fourni par un synthétiseur de fréquence.

De plus, bien que l'on ait supposé des fronts raides des signaux d'horloge, les déclenchements des différentes bascules dépendent en pratique de leurs structures et de leurs caractéristiques en termes de temps d'établissement (set up time) et de maintien (hold time) nécessaires pour enregistrer l'état. Cela ne change toutefois rien au fonctionnement exposé ci-dessus de l'invention.

En outre, la mise en oeuvre de l'invention est à la portée de l'homme du métier à partir des indications fonctionnelles données ci-dessus en fonction de l'application, notamment pour ce qui concerne le paramétrage du nombre de bits du motif de référence, de la fréquence de mesure et du seuil de détection. Le nombre de bits formant le mot à comparer au motif de référence peut d'ailleurs comprendre tout ou partie des sorties du registre à décalage.

Enfin, l'invention s'applique également au cas où le signal à mesurer est sous échantillonné avant le registre à décalage. Dans ce cas, le mot de référence est construit en fonction du rapport d'échantillonnage (pair ou impair) et comporte un groupe d'un ou plusieurs premiers bits dans un premier état suivi d'un groupe de bits dans le même état (rapport d'échantillonnage pair) ou dans l'état inverse (rapport d'échantillonnage impair). La fin du mot est alors constituée d'un groupe de derniers bits ayant, pour un rapport d'échantillonnage pair un état dépendant du nombre de bits intermédiaires entre les premier et dernier groupes ou, pour un rapport d'échantillonnage impair, d'un groupe de bits identique au premier groupe.

## Revendications

1. Procédé d'estimation de gigue d'un premier signal périodique (CKint) par rapport à un deuxième signal périodique (CKref), comportant des étapes de :
échantillonner (32, 33) le premier signal au moyen du deuxième ;
fournir le résultat de l'échantillonnage en entrée d'un registre à décalage (21) déclenché par le deuxième signal, **caractérisé en ce qu'**il comporte au moins des étapes de :
comparer (41) au moins les deux premiers états et le dernier état d'un mot courant formé à partir de sorties parallèles du registre à décalage par rapport à un mot de référence (43) ; et
compter (35, 36) le nombre d'occurrences du mot de référence dans une période de mesure donnée.

2. Procédé selon la revendication 1, dans lequel le nombre d'occurrences est comparé à un seuil (TH) et est périodiquement réinitialisé, la gigue étant considéré comme acceptable tant que ce seuil n'est pas atteint.

3. Procédé selon l'une quelconque des revendications 1 et 2, dans lequel les premiers et derniers bits du mot de référence sont identiques, le deuxième bit de ce mot étant dans un état inverse.

4. Procédé selon l'une quelconque des revendications 1 à 3, dans lequel le motif de référence comporte entre un et trois premiers bits dans un premier état, entre un et trois bits suivants dans un deuxième état inverse au premier état et entre un et trois derniers bits dans le premier état.

5. Procédé selon l'une quelconque des revendications 1 à 4, dans lequel le mot courant fourni par le registre à décalage (21) est comparé à un deuxième mot de référence inverse par rapport au premier.

6. Procédé selon l'une quelconque des revendications 1 à 5, dans lequel la période de mesure est choisie en fonction de la période de l'horloge de référence.

7. Procédé selon l'une quelconque des revendications 1 à 6, dans lequel le nombre de bits du mot de référence est compris entre quatre et douze, de préférence entre cinq et sept.

8. Procédé selon l'une quelconque des revendications 1 à 7, dans lequel le mot courant est formé de toutes les sorties du registre à décalage.

9. Procédé selon l'une quelconque des revendications 1 à 7, dans lequel le mot courant est formé d'une partie seulement des sorties du registre à décalage.

10. Dispositif d'estimation de gigue d'un signal périodique (CKint) par rapport à un signal de référence (CKref), comportant un registre à décalage (31) dont une entrée reçoit le signal périodique, échantillonné par le signal de référence, **caractérisé en ce qu'**il comporte :
un comparateur (41) d'un mot courant constitué des sorties parallèles du registre à décalage par rapport à un mot de référence (43) ;
au moins un compteur (35, 36) d'occurrences d'une comparaison positive fournie par le premier comparateur ; et
un deuxième comparateur (37) du résultat du compteur d'occurrences par rapport à un seuil (TH).

11. Circuit selon la revendication 10, adapté à la mise en oeuvre du procédé selon l'une quelconque des revendications 1 à 9.

## Claims

1. A method for estimating the jitter of a first periodic signal (CKint) with respect to a second periodic signal (CKref) comprising steps of:
sampling (32, 33) the first signal by means of the second one;
providing the result of the sampling to the input of a shift register (21) triggered by the second signal,
**characterized in that** it comprises at least steps of:
comparing (41) at least the first two states and the last state of a current word formed from parallel outputs of the shift register with respect to a reference word (43); and
counting (35, 36) the number of occurrences of the reference word within a given measurement period.

2. The method of claim 1, wherein the number of occurrences is compared with a threshold (TH) and is periodically reset, the jitter being considered as acceptable as long as this threshold has not been reached.

3. The method of claim 1 or 2, wherein the first and last bits of the reference word are identical, the second bit of this word being in an inverse state.

4. The method of any of claims 1 to 3, wherein the reference word comprises between one and three first bits in a first state, between one and three next bits in a second state inverse to the first state, and between one and three last bits in the first state.

5. The method of any of claims 1 to 4, wherein the current word provided by the shift register (21) is compared with a second reference word inverse with respect to the first one.

6. The method of any of claims 1 to 5, wherein the measurement period is selected according to the period of the reference clock.

7. The method of any of claims 1 to 6, wherein the number of bits of the reference word ranges between four and twelve, preferably between five and seven.

8. The method of any of claims 1 to 7, wherein the current word is formed of all the outputs of the shift register.

9. The method of any of claims 1 to 7, wherein the current word is formed of a portion only of the outputs of the shift register.

10. A device for estimating the jitter of a periodic signal (CKint) with respect to a reference signal (CKref), comprising a shift register (31) having an input receiving the periodic signal, sampled by the reference signal, **characterized in that** it comprises:
a comparator (41) of a word formed of the parallel outputs of the shift register with respect to a reference pattern (43);
at least one counter (35, 36) of occurrences of a positive comparison provided by the first comparator; and
a second comparator (37) of the result of the occurrence counter with respect to a threshold (TH).

11. The circuit of claim 10, adapted to the implementation of the method of any of claims 1 to 9.

## Patentansprüche

1. Ein Verfahren zum Schätzen der Schwankungen (Jitter) eines ersten periodischen Signals (CKint) bezüglich eines zweiten periodischen Signals (CKref), wobei folgende Schritte vorgesehen sind:
Tasten (Sampling) (32, 33) des ersten Signals mittels des zweiten Signals;
Liefern des Resultats des Tastens an den Eingang eines Schieberegisters (21) ausgelöst durch das zweite Signal,
**dadurch gekennzeichnet, dass** mindestens die folgenden Schritte vorgesehen sind:
Vergleichen (41) von mindestens den ersten beiden Zuständen und dem letzten Zustand eines laufenden Wortes gebildet aus parallelen Ausgangsgrößen des Schieberegisters bezüglich eines Bezugswortes (43); und
Zählen (35, 36) der Anzahl des Auftretens des Bezugswortes innerhalb einer gegebenen Messperiode.

2. Verfahren nach Anspruch 1, wobei die Anzahl des Auftretens mit einer Schwelle (TH) verglichen wird und periodisch zurückgesetzt wird, wobei die Schwankungen als akzeptabel angesehen werden, solange diese Schwelle noch nicht erreicht ist.

3. Verfahren nach Anspruch 1 oder 2, wobei das erste und das letzte Bit des Bezugswortes identisch sind, wobei das zweite Bit dieses Wortes in einem inversen Zustand ist.

4. Verfahren nach einem der Ansprüche 1 bis 3, wobei das Bezugswort zwischen einem und drei ersten Bits in einem ersten Zustand aufweist, zwischen einem und drei nächsten Bits in einem zweiten Zustand invers zum ersten Zustand und zwischen einem und drei letzten Bits in dem ersten Zustand.

5. Verfahren nach einem der Ansprüche 1 bis 4, wobei das laufende Wort vorgesehen durch das Schieberegister (21) mit einem zweiten Bezugswort invers bezüglich des ersten Bezugsworts verglichen wird.

6. Verfahren nach einem der Ansprüche 1 bis 5, wobei die Messperiode entsprechend der Periode des Bezugstaktes ausgewählt wird.

7. Verfahren nach einem der Ansprüche 1 bis 6, wobei die Anzahl der Bits des Bezugswortes im Bereich zwischen vier und zwölf liegt, vorzugsweise zwischen fünf und sieben.

8. Verfahren nach einem der Ansprüche 1 bis 7, wobei das laufende Wort aus allen Ausgangsgrößen des Schieberegisters geformt wird.

9. Verfahren nach einem der Ansprüche 1 bis 7, wobei das laufende Wort von nur einem Teil der Ausgangsgrößen des Schieberegisters gebildet wird.

10. Eine Vorrichtung zum Schätzen der Schwankungen eines periodischen Signals (CKint) bezüglich eines Bezugssignals (CKref), wobei folgendes vorgesehen ist:
ein Schieberegister (31) mit einem das periodische Signal empfangenden Eingang, und zwar getastet durch das Bezugssignal, **dadurch gekennzeichnet, dass** folgendes vorgesehen ist:
ein Komparator (41) eines Wortes, geformt von den parallelen Ausgängen des Schieberegisters bezüglich eines Bezugsmusters (43);
mindestens einen Zähler (35, 36) des Auftretens (der Auftritte) eines positiven Vergleichs vorgesehen durch den ersten Komparator; und
einen zweiten Komparator (37) des Resultats des Auftrittszählers bezüglich einer Schwelle (TH).

11. Schaltung nach Anspruch 10, geeignet für Implementierung des Verfahrens nach irgendeinem der Ansprüche 1 bis 9.
